## Europäisches Patentamt

## European Patent Office

## Office européen des brevets

(11) Publication number: **0 096 857**
**B1**

## EUROPEAN PATENT SPECIFICATION

(45) Date of publication of patent specification: **31.01.90**

(51) Int. Cl.⁵: **H 03 H 19/00**

(21) Application number: **83105677.5**

(22) Date of filing: **10.06.83**

(54) Transmission filter with biquadratic filter stages.

(30) Priority: **11.06.82 BE 2059738**

(43) Date of publication of application:
**28.12.83 Bulletin 83/52**

(45) Publication of the grant of the patent:
**31.01.90 Bulletin 90/05**

(84) Designated Contracting States:
**DE FR GB**

(56) References cited:
**THE BELL SYSTEM TECHNICAL JOURNAL, vol. 61, no. 5, May-June 1982, pages 685-707, New York, US; K.R. Laker et al.: "Parasitic insensitive, biphase switched capacitor filters realized with one operational amplifier per pole pair"**

**IEEE TRANSACTIONS ON CIRCUITS AND SYSTEMS, vol. CAS-24, no. 11, November 1977, pages 590-597, New York, US; D. Dubois et al.: "Synthesis of a leapfrog configuration equivalent to an LC-ladder filter between generalized terminations"**

(73) Proprietor: **ALCATEL N.V.**
**Strawinskylaan 537 (World Trade Center)**
**NL-1077 XX Amsterdam (NL)**

(72) Inventor: **Guebels, Pierre-Paul François M.M.**
**Ter Voortlaan 99**
**B-2520 Edegem (BE)**

(74) Representative: **Graf, Georg Hugo, Dipl.-Ing. et al**
**Standard Elektrik Lorenz AG Patent- und Lizenzwesen Postfach 30 09 29**
**D-7000 Stuttgart 30 (DE)**

(56) References cited:
**PROCEEDINGS OF THE 1981 EUROPEAN CONFERENCE ON CIRCUIT THEORY AND DESIGN, no. 36, 25-28 August 1981, pages 803-807, The Hague, NL; Sven Eriksson: "An approach to the realization of switched-capacitor filters using the bilinear transformation"**

Courier Press, Leamington Spa, England.

**Description**

The present invention relates to a leapfrog filter including a plurality of biquadratic filter stages coupled in a leapfrog configuration.

Such a filter is generally known in the art e.g. from the article "Synthesis of a leapfrog configuration equivalent to an LC-ladder filter between generalized terminations" by D. Dubois and J. Neirynck, published in the IEEE Transactions on Circuits and Systems, Vol. CAS-24, No. 11, November 1977, pp. 590—597. The numerator of the transfer function of such a filter is even and can only have pairs of real transmission zeros at z=1 and z=−1 in the z-plane. However, it may be necessary in some circumstances to have single real transmission zeros at z=+1 and/or at z=−1, e.g. for the realization of a bandpass filter.

A first object of the present invention is to provide a leapfrog filter of the above type but having a transfer function with an odd numerator and more particularly with at least three real transmission zeros at z=±1 and at least one real transmission zero at z=∓1 in the z-plane.

Reference is now made to the above article and to that by M. Hasler published in the IEEE Transactions on Circuits and Systems, Vol. CAS-27, No. 7, July 1980, pp. 636—641, and entitled "A new class of RC-active filters using FDNR elements and generalized terminations". From these it follows that a leapfrog filter comprising a real reciprocal non-dissipative 2-port connected between real non-dissipative terminations has a minimum sensitivity to component variations at the frequencies where the frequency dependent filter polynomial h defined below is equal to zero, i.e. at the frequencies (attenuation zeros) where the maximum power transfer occurs (Orchard-Fettweis theorem).

The scattering matrix S of such a 2-port defined with respect to real termination impedances $W_1$ and $W_2$ has the form

$$S = \frac{1}{g} \begin{vmatrix} h & f\dfrac{N}{D} \\ \pm f & \mp h_- \end{vmatrix}$$

where:

N, D are coprime polynomials such that

$$\frac{W_1}{W_2} = \frac{N}{D};$$

f, g and h are frequency dependent polynomials subject to the following conditions:
f is even or odd and divisible by D and the upper sign of f corresponds to the upper sign of $h_-$
g is a strictly Hurwitz polynomial, i.e. its zeros are in the open left half of the s-plane;

$$gg_- = hh_- + \frac{N}{D} ff_- \tag{1}$$

wherein
$f_- = f_-(s) = f(-s)$
$g_- = g_-(s) = g(-s)$
$h_- = h_-(s) = h(-s)$
a function with a − as subscript being the so-called Hurwitz conjugate of the function, i.e. a function of s wherein −s has been substituted for the complex frequency s.

In the filter passband and when it is substantially flat, the voltage transfer function f/2g is substantially equal to unity and $ff_-/gg_-$ is substantially a constant. From the above relation (1) which is a related form of the Feldtkeller relation, it follows that in order to have a maximum number of zeros of h in the passband, the function N/D should be as constant (or flat) as possible. However, according to the article by M. Hasler, this choice of N/D has merely permitted to place one pair of complex conjugate zeros of h onto the imaginary axis in the s-plane.

A further object of the present invention is to provide a leapfrog filter of the above type, but which does not require N/D to be substantially constant (or flat) in the passband so as to reach therein a minimum sensitivity to filter component variations.

According to the invention the above objects are achieved due to the fact that the present leapfrog filter is a sampled filter with characteristics equivalent to those of a filter comprising the cascade connection of a first filter part having a transfer function proportional to

$$\frac{z \pm 1}{z \mp 1}$$

and of a second filter part comprising a plurality of biquadratic filter stages coupled in leapfrog configuration the first and the last stages of which are dissipative for reactive pseudo-power and each have a transfer function proportional to a same factor $(z\mp1)^2$ and the other stages being non-dissipative for reactive pseudo-power, wherein $z=e^{sT}$ with s being the complex frequency and T being the sampling period of the filter.

Because the total transfer function of the filter is hence proportional

$$\frac{z\pm1}{z\mp1}(z\mp1)^4=(z\pm1)(z\mp1)^3$$

the filter has at least three real transmission zeros at $z=\pm1$ and one transmission zero at $z=\mp1$ and the numerator of its transfer function is odd. It should be noted that the factor

$$\frac{z\pm1}{z\mp1}$$

does not affect the degree of the filter.

The invention is based on the insight that when one puts an additional stage with transfer function

$$\frac{z\pm1}{z\mp1}$$

in cascade with the input of the above mentioned lossless 2-port and thus multiplies the overall transfer function by this factor, it is necessary if the overall (unity) transfer function in the passband should remain unchanged to multiply ff_/gg_ in the passband by about

$$\frac{(z\mp1)^2}{z\pm1}.$$

From the above relation (1) it then follows that for sensitivity reasons, i.e. to have h equal to zero, one should take

$$\frac{N}{D}=\frac{(z\pm1)^2}{(z\mp1)^2}$$

instead of N/D having to be substantially flat as indicated by M. Hasler. This leads to the choice of the bilinear transfer functions for the terminations $W_1$ and $W_2$, i.e.

$$W_1=q_1\frac{z\pm1}{z\mp1}$$

and

$$W_2=\frac{1}{q_2}\frac{z\mp1}{z\pm1}$$

($q_1$ and $q_2$ are constants)

Due to N/D being no longer flat it has been possible to place a maximum number of zeros of h in the passband.

Another characteristic feature of the present leapfrog filter is that the factor $(z\mp1)^2$ to which the transfer function of said first stage is proportional is the numerator of a function

$$T'_1=\frac{T_1}{1+W_1T_1}=h'_1\cdot\frac{(z\mp1)^2}{z^2-2zR_1\cos t'_{p1}+R_1^2}$$

wherein

$$W_1=q_1\frac{z\pm1}{z\mp1}$$

is the transfer function of said first termination stage ($W_1$) and

$$T_1 = h_1 \frac{(z\mp1)^2}{z^2 - 2z \cos t_{p1} + 1}$$

is the transfer function of the first biquadratic filter stage of said two-port, and wherein $h_1$, $h'_1$ and $q_1$ are positive constants and $t_{p1}$ is the angle of a transmission pole of $T_1$ in the z-plane defined by $z = e^{sT}$.

Still another characteristic feature of the present leapfrog filter is that the factor to which the transfer function of said last stage is proportional, is the numerator of a function

$$T'_m = \frac{T_m}{1 + W_2^{-1}T_m} = h'_m \cdot \frac{(z\mp1)^2}{z^2 - 2zR_m \cos t'_{pm} + R_m^2}$$

wherein

$$W_2 = \frac{1}{q_2} \cdot \frac{z\mp1}{z\pm1}$$

is the transfer function of said second terminal stage ($W_2$) and

$$T_m = h_m \frac{(z\mp1)^2}{z^2 - 2z \cos t_{pm} + 1}$$

is the transfer function of the last biquadratic stage of said two-port and wherein $h_m$, $h'_m$ and $q_2$ are positive constants and $t_{pm}$ is the angle of a transmission pole of $T_m$ in the z-plane defined by $z = e^{sT}$.

Thus each termination stage and the adjacent stage of the two-part are combined to constitute a new biquadratic filter stage.

Yet another characteristic feature of the present leapfrog filter is that it includes a biquadratic filter input stage with a first input constituting the input of the leapfrog filter, a second input and an output and includes a forward circuit between said first input and said output which realizes the transfer function of said first filter part and a feedback circuit between said second input and said output which realizes the transfer function of said first stage of said second filter part.

Thus a same biquadratic filter stage is used for realizing, on the one hand, the transfer function partly resulting from the additional stage with transfer function

$$\frac{z\pm1}{z\mp1}$$

and, on the other hand, of the transfer function of the first stage of said second filter part.

The present invention also relates to a switched capacitor biquadratic filter circuit with an input and an output and including a non-overlapping two-phase clock source and first and second operational amplifiers each having an inverting input, a grounded non-inverting input, an output and a feedback capacitance, the output of said first amplifier being coupled to the input of said second amplifier via first capacitance means including a first capacitance the plates of which are connected to first and second change-over switches able, under the control of said clock source, to connect them between a ground and said output of said first amplifier and between said ground and the input of said second amplifier, the output of said second amplifier being coupled to the input of said first amplifier via second capacitance means including a second capacitance the plates of which are connected to third and fourth changeover switches able under the control of said clock source, to connect them between said ground and the output of said second amplifier and between said ground and said input of said first amplifier, and said filter input being coupled to an input of one of said amplifiers via third capacitance means including at least a third capacitance.

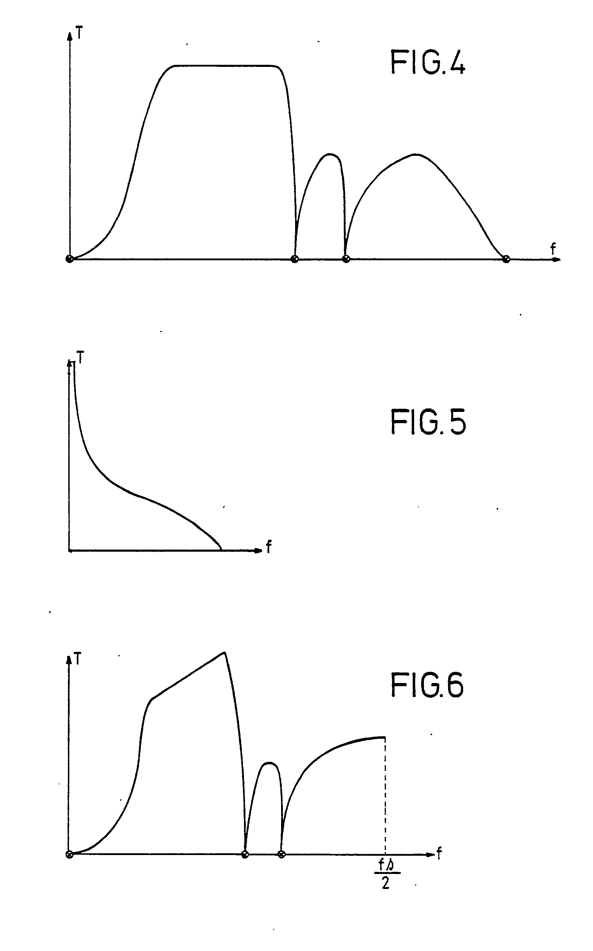

Such biquadratic filter stages realized in switched capacitor technique have already been designed and are for instance disclosed in the article "An NMOS analog building block for telecommunication applications" by P. E. Fleischer et al, published in IEEE Transaction on Circuits and Systems, Vol. CAS-27, No. 6, June 1980, pp. 552—559 and more particularly in Fig. 5 thereof.

Another object of the present invention is to provide switched capacitor biquadratic filter stages which are insensitive to parasitic capacitances and particularly adapted for use in leapfrog filters previously defined.

According to the invention such an object is achieved by a switched capacitor biquadratic filter wherein said clock source controls said switches in such a way that said second capacitor is connected to the input of said first amplifier and said first capacitor is connected to said input of said second amplifier for respective different phases of said clock source.

The present invention also relates to a switched capacitor biquadratic filter circuit, characterized in that it simultaneously realizes a transfer function proportional to $z^2-1$ between a first input and an output and a second transfer function proportional to $(z\mp1)^2$ between a second input and said output the transfer functions being considered in the z-plane.

Such a filter circuit can thus be directly used to realize the above mentioned input stage of a leapfrog filter defined above.

The above mentioned and other objects and features of the invention will become more apparent and the invention itself will be best understood by referring to the following description of embodiments taken in conjunction with the accompanying drawings wherein:

Fig. 1 is a block diagram of a subscriber line circuit SLC for use in a PCM telephone system and incorporating leapfrog filters TBPF and RLPF according to the invention;

Fig. 2 is a flowgraph of a classical leapfrog filter;

Fig. 3 is a flowgraph of a leapfrog filter according to the invention;

Figs. 4, 5 and 6 show transfer function versus frequency characteristics used to explain the invention;

Fig. 7 is a flowgraph of a leapfrog filter according to the invention;

Fig. 8 is a modified version of the flowgraph of Fig. 7;

Figs. 9 to 16 represent various switched capacitor biquadratic filter stages according to the invention;

Fig. 17 shows the transmit bandpass filter TBPF of Fig. 1 in detail;

Fig. 18 represents the attenuation versus frequency characteristic of the filter of Fig. 17;

Fig. 19 shows the group delay versus frequency characteristic of the filter of Fig. 17;

Fig. 20 represents the lowpass filter RLPF of Fig. 1 in detail;

Fig. 21 shows the attenuation versus frequency characteristic of the filter of Fig. 20.

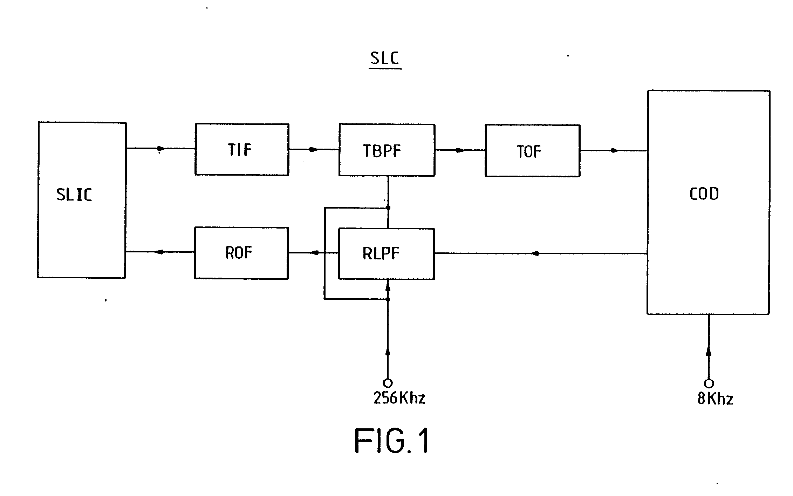

The subscriber line circuit SLC for a PCM telephone switching system shown in Fig. 1 includes a subscriber line interface circuit SLIC which is connected to a coder/decoder circuit or codec COD, operating at 8 kHz, via the cascade connection of an anti-aliasing transmit filter TIF, a transmit bandpass filter TBPF and a smoothing transmit filter TOF, whilst the codec COD, is connected to the SLIC via the cascade connection of a receive lowpass filter RLPF and a smoothing receive filter ROF.

The filters TIF, TOF, ROF all are of the second order Sallen-Key type. The bandpass filter TBPF is an eighth-order switched capacitor leapfrog filter operating as an anti-alias filter and rejecting 50 Hz and 60 Hz power supply frequencies. The lowpass filter RLPF is a fourth-order switched capacitor leapfrog filter having substantially the same lowpass characteristic as the TBPF and realizing a

$$\frac{\sin x}{x}$$

correction for the sampling operation in the codec. In both filters the capacitors ratio has a minimum dispersion and the filters have a small sensitivity to component variations and use a single clock frequency of 256 kHz.

Switched capacitor filters for use in a subscriber line circuit for a PCM telephone switching system are already known from the following articles, both published in the IEEE Journal of Solid-State Circuits, Vol. SC-15, No. 6, December 1980, and entitled "A precision low-power PCM channel filter with on-chip power supply regulation" by H. Ohara et al, pp. 1005—1013, and "A low-power NMOS transmit-receive IC filter for PCM telephony" by I. A. Young, pp. 997—1005. None of these circuits however includes an eighth order leapfrog bandpass filter and a fourth order leapfrog lowpass filter.

A structure comprising a 2-port which is lossless for reactive power and connected to terminations $W_1$ and $W_2$ which are dissipative for reactive power will now be considered. In fact the power is pseudo power because it cannot be measured. This 2-port is constituted by a plurality of biquadratic filter stages $T_1$ to $T_m$ which are arranged in a leapfrog configuration. These stages have an infinite quality factor and transfer functions which are even functions because they are lossless for reactive power. On the contrary, the transfer functions of the termination stages $W_1$ and $W_2$ are odd functions because they are dissipative for reactive power. The termination stage $W_1$ is connected in series with a generator e (having zero impedance) across the input $I_1, I_2$ of the 2-port and thus provides a voltage $e-W_1I'_1$ ($I'_1$ being the input current) across the input. In the flowgraph this is represented by the connection $a=e-W_1b$. The termination stage $W_2$ is connected across the output $O_1, O_2$ of the 2-port and thus provides a voltage $v=W_2I'_2$ ($I'_2$ being the output current) across the output. Because

$$I'_2=v(-W_2)^{-1}$$

in the flowgraph this is represented by $c=(-W_2)^{-1}d$.

As the stages $T_1$ to $T_m$ have an infinite quality factor,

$$T_i=h_i\frac{z^2-2z\cos t_{oi}+1}{z^2-2z\cos t_{pi}+1} \qquad (2)$$

5

wherein $h_i$ is a constant with $i=1$ to $m$ and $t_{oi}$ and $t_{pi}$ are the angles in the z-plane of the transmission zero and pole of $T_i$ respectively.

The circuit comprising $-W_1$ and the stage $T_1$, on the one hand, and the circuit comprising $-W_2^{-1}$ and the stage $T_m$ on the other hand can be realized by the biquadratic stages $T'_1$ and $T'_m$ respectively, the transfer functions of which are related to those of $W_1$, $T_1$ and $W_2^{-1}$, $T_m$ by

$$T'_1 = \frac{T_1}{1+W_1 T_1} \tag{3}$$

and

$$T'_m = \frac{T_m}{1+W_2^{-1} T_m} \tag{4}$$

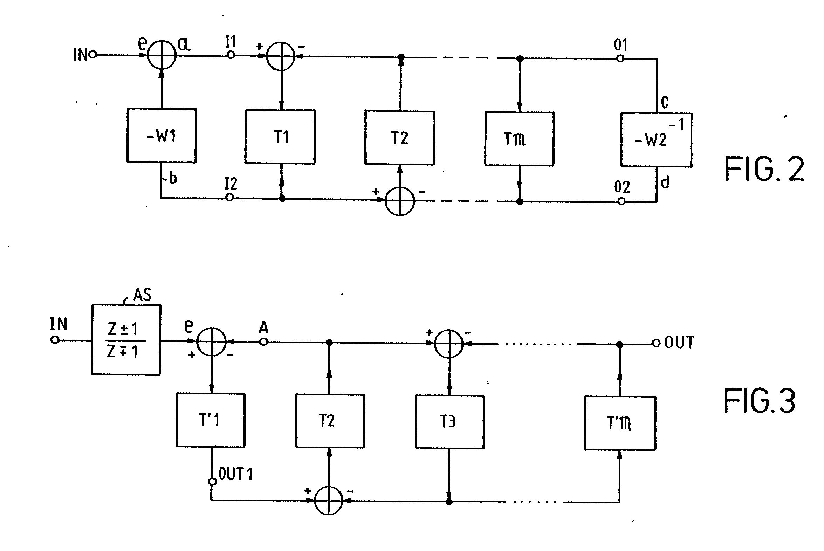

These end stages $T'_1$ and $T'_m$ are shown in Fig. 3 (to be considered without the additional stage AS).

In order that $T'_1$ and $T'_m$ should be biquadratic functions the transmission poles of $W_1$ should be the transmission zeros of $T_1$ and the transmission poles of $W_2^{-1}$ should be the transmission zeros of $T_m$. Moreover because $W_1$ and $W_2$ are dissipative for reactive power their transfer functions have to be odd. For this reason, $W_1$ and $W_2$ have been chosen as follows:

$$W_1 = q_1 \frac{z^2-1}{z^2-2z \cos t_{o1}+1} \tag{5}$$

$$W_2 = q_2 \frac{z^2-1}{z^2-2z \cos t_{om}+1} \tag{6}$$

By combining the relations (2) to (6) one obtains:

$$T'_1 = h'_1 \frac{z^2-2z \cos t_{o1}+1}{z^2-2zR_1 \cos t'_{p1}+R_1^2} \tag{7}$$

$$T'_m = h'_m \frac{z^2-2z \cos t_{om}+1}{z^2-2zR_m \cos t'_{pm}+R_m^2} \tag{8}$$

where

$$h'_1 = \frac{h_1}{1+q_1 h_1}; \qquad R_1 = \frac{1-q_1 h_1}{1+q_1 h_1}$$

$$h'_m = \frac{h_m}{1+q_2 h_m}; \qquad R_m = \frac{1-q_2 h_m}{1+q_2 h_m}$$

$$\cos t'_{p1} = \frac{\cos t_{p1}}{\sqrt{1-q_1^2 h_1^2}}$$

$$\cos t'_{pm} = \frac{\cos t_{pm}}{\sqrt{1-q_2^2 h_m^2}}$$

$T'_1$ and $T'_m$ are damped stages.

From the relations (5) and (6) it follows that:

$$\frac{N}{D} = \frac{W_1}{W_2} = q_1 q_2 \frac{(z^2-1)^2}{(z^2-2z \cos t'_{o1}+1)(z^2-2z \cos t'_{om}+1)} \tag{9}$$

From the above it also follows that the transfer function of the leapfrog filter shown in Fig. 3 (and considered without the stage AS) is of even order and has an even numerator.

Reference is now made to the latter figure, but now with the additional stage AS having a transfer function equal to

$$\frac{z\pm1}{z\mp1}$$

As already explained in the introduction, this additional stage leads to the following choice of the function N/D, i.e.

$$\frac{N}{D} = \frac{W_1}{W_2} = \frac{(z\mp1)^2}{(z\pm1)^2} \qquad (10)$$

To satisfy this relation, $W_1$ and $W_2$ (see previous relations 5 and 6) have now been chosen as follows:

$$W_1 = q_1 \frac{z^2-1}{(z\mp1)^2} = q_1 \frac{z\pm1}{z\mp1} \qquad (11)$$

i.e. relation (5) with $\cos t_{o1} = \pm1$

$$W_2 = \frac{1}{q_2} \frac{(z\mp1)^2}{z^2-1} = \frac{1}{q_2} \frac{z\mp1}{z\pm1} \qquad (12)$$

i.e. relation (6) with $\cos t_{om} = \pm1$.

In this case $T'_1$ and $T'_m$ (see previous relations (7) and (8) become:

$$T'_1 = h'_1 \frac{(z\mp1)^2}{z^2-2zR_1 \cos t'_{p1}+R_1^2} = \frac{(z\mp1)^2}{p_1} \qquad (13)$$

$$T'_m = h'_2 \frac{(z\mp1)^2}{z^2-2zR_m \cos t'_{pm}+R_m^2} = \frac{(z\mp1)^2}{p_m} \qquad (14)$$

The numerator of the transfer function of the filter can therefore be written

$$\frac{z\pm1}{z\mp1} \cdot (z\mp1)^2(z^2-2z \cos t_{o2}+1)... (z\mp1)^2$$

Because

$$\frac{z\pm1}{z\mp1}(z\mp1)^4 = (z\pm1)(z\mp1)^3$$

this transfer function thus has at least three transmission zeros at $z=\pm1$ and at least one transmission zero at $z=\mp1$.

The structure of Fig. 3 permits, for instance, to realize a PCM bandpass filter operating at a sampling frequency $f_s$ and having a transfer function T/frequency characteristic such as shown in Fig. 4 i.e. with a flat passband and with three real zeros at frequency zero (DC) and one real zero at half the sampling frequency $f_s$, i.e. in the z-plane at $z=1$ and at $z=-1$ respectively. The transfer function T shown in Fig. 4 is a combination of the transfer function e.g.

$$\frac{z+1}{z-1}$$

of the additional stage AS (Fig. 3) and shown in Fig. 5 and of the transfer function represented in Fig. 6 of the filter part $T'_1$, $T_2$, $T_3$, $T'_m$ (Fig. 3). As follows from Fig. 5,

$$- \frac{z+1}{z-1}$$

has a real transmission zero at $z=-1$ and a real transmission pole at $z=+1$, whilst the filter part $T'_1-T'_m$ has four real transmission zeros at zero frequency (i.e. $z=+1$) and one real transmission zero at

$$\frac{fs}{2}(z=-1).$$

The overall filter has three real transmission zeros at frequency zero and one real transmission zero at fs/2 because the transmission pole at $z=+1$ of Fig. 5 compensating a transmission zero at $z=+1$ of Fig. 4. On the other hand from Figs. 4 to 6 it also follows that in the passband the slope of Fig. 5 compensates that of Fig. 6 to provide the flat passband of Fig. 4. This inclined passband permits to place a maximum of attenuation zeros of the polynome h in this passband.

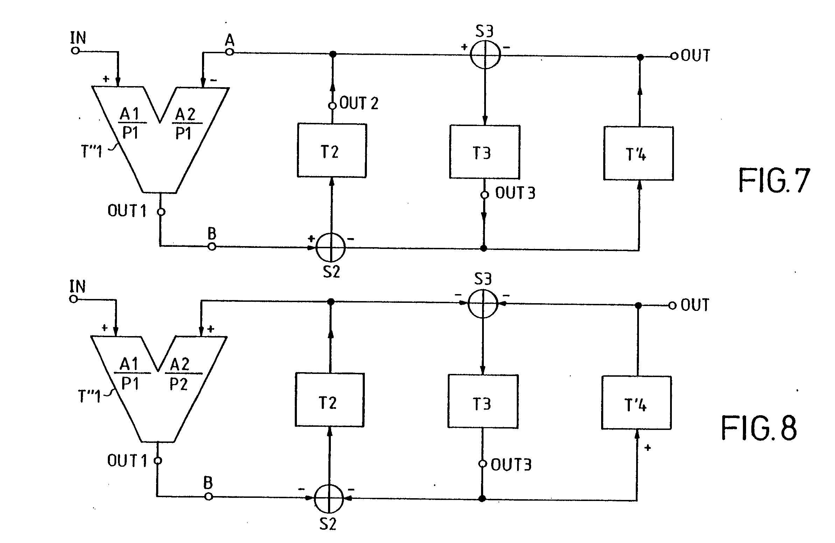

The stages $T'_1$ and AS in Fig. 3 can be realized by a single equivalent biquadratic filter stage $T''_1$ shown in the flowgraph of Fig. 7 (where m=4). $T''_1$ has a forward path with transfer function

$$\frac{A_1}{p_1} = \frac{z^2-1}{p_1}$$

and a feedback path with transfer function

$$\frac{A_2}{p_1} = \frac{(z\mp1)^2}{p_1},$$

$p_1$ being the denominator of $T'_1$ in the relation 13 given above. Indeed, in the structure of Fig. 3 the transfer function of the forward path from IN to the output $OUT_1$ of $T'_1$ is equal to

$$\frac{z\pm1}{z\mp1} \cdot T'_1 \quad \text{or to} \quad \frac{z^2-1}{p_1}$$

when taking relation (13) into account, and the transfer function of the feedback path from point A to output $OUT_1$ is equal to

$$T'_1 = \frac{(z\mp1)^2}{p_1}$$

In the structure of Fig. 7 the signals at the summing points $S_2$ and $S_3$ have a different sign because the forward signals are plus signals, whereas the feedback signals are minus signals. For this reason the structure cannot be realized directly. On the other hand it is desirable to have as much negative signals as possible because biquadratic filter stages with a negative output signal (a negative $h_i$) have been designed and are thus available, as will be explained later. Therefore the signals in the flowgraph of Fig. 7 have been manipulated to remove a maximum number of positive signals. The result is shown in Fig. 8 but is still not satisfactory because still two positive signals remain which will give rise to some difficulty because they require the use of non-existent negative capacitances.

The structure of Fig. 8 will now be used to realize an 8th order bandpass leapfrog filter having a transfer function with an odd numerator and making use of switched capacitor biquadratic filter stages which are insensitive to parasitic capacitances.

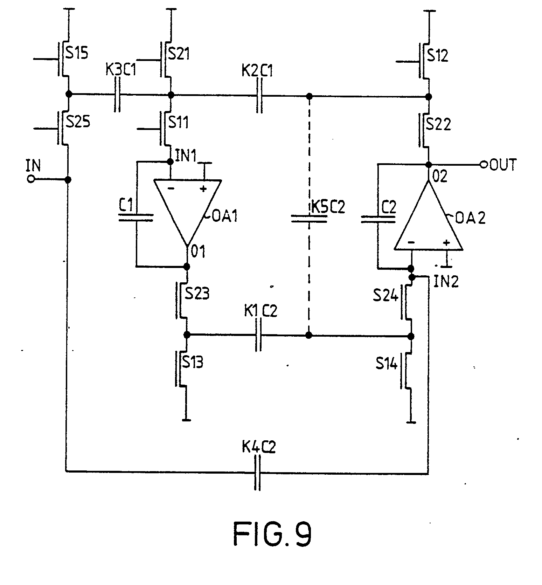

As mentioned above, the internal biquadratic filter stages such as $T_2$ and $T_3$ of the above considered leapfrog filter have an infinite quality factor and a small sensitivity to component variations, whereas the biquadratic end stages $T''_1$ and $T'_4$ are damped stages and should have a sensitivity which is as small as possible (for the quality factor). Such non-damped and damped stages are shown in Figs. 9 to 16 representing more particularly switched capacitor biquadratic stages which are each insensitive to parasitic capacitances. Some of these stages are known from the above mentioned article of P. E. Fleischer et al. Each of these stages makes use of:
— two operational amplifiers OA1 and OA2;
— a two-phase clock (not shown) with non-overlapping phases;
— MOS switches such as S11, S12,... and S21, S22,... the first indicia indicating the phase of the clock which has to be applied to close the switch;

—four capacitor connecting circuits which are insensitive to parasitic capacitors, i.e.

= a first or non-inverting type, hereinafter called $TP_1$, such as shown in the upper left part of Fig. 9 and able to connect a capacitor ($k_3C_1$) between an input (IN) and ground via switches ($S_{25}$, $S_{15}$) during one clock phase (here clock phase 2 or $CP_2$) and able to connect this capacitor between ground and an input ($IN_1$) of an operational amplifier ($OA_1$) via switches ($S_{15}$, $S_{11}$) during another clock phase (here clock phase 1 or $CP_1$);

= a second or inverting type, hereinafter called $TP_2$, such as shown in the lower part of Fig. 9 and able to connect a capacitor ($k_1C_2$) between two grounds via switches ($S_{13}$, $S_{14}$) and during one clock phase ($CP_1$) and able to connect this capacitor between an output (of OA1) and an input ($IN_2$) of an operational amplifier ($OA_2$) via switches ($S_{23}$, $S_{24}$) during another clock phase ($CP_2$);

= a third type, hereinafter called $TP_3$, such as shown in Fig. 9 and connecting a capacitor ($k_4C_2$) directly to an input ($IN_2$) of an operational amplifier ($OA_2$);

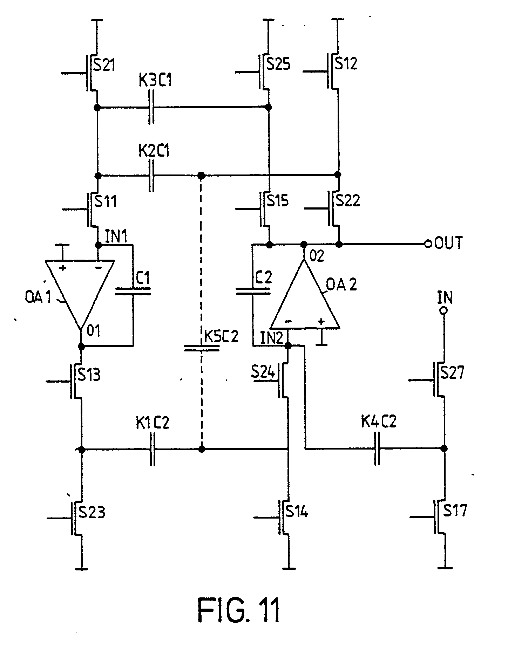

= a fourth type, hereinafter called $TP_4$, such as shown in Fig. 11 and which includes a capacitor ($k_4C_2$) one plate of which is permanently connected to an input ($IN_2$) of an operational amplifier ($OA_2$) and the other plate of which can be connected to ground via a switch and during one clock phase ($CP_1$). During the other clock phase the circuit is able to connect capacitor $k_4C_2$ between a circuit input (IN) and an input ($IN_2$) of an operational amplifier ($OA_2$).

The biquadratic filter stage of Fig. 9 can be characterized as follows:

— output $O_2$ of $OA_2$ is coupled to input $IN_1$ of $OA_1$ via a capacitor connecting circuit ($S_{11}$, $S_{21}$, $S_{12}$, $S_{22}$, $k_2C_1$) of type $TP_1$ which connects capacitor $k_2C_1$ to $IN_1$ on clock phase $CP_1$;

— input IN is coupled to $IN_1$ via a capacitor connecting circuit ($S_{11}$, $S_{21}$, $S_{15}$, $S_{25}$) of type $TP_1$ which connects capacitor $k_3C_1$ to $IN_1$ on clock phase $CP_1$;

— output $O_1$ of $OA_1$ is coupled to input $IN_2$ of $OA_2$ via a capacitor connecting circuit $S_{13}$, $S_{23}$, $S_{14}$, $S_{24}$, $k_1C_2$) of type $TP_2$ which connects capacitor $k_1C_2$ to $IN_2$ on clock phase $CP_2$;

— input IN is coupled to $IN_2$ via a capacitor connecting circuit $k_4C_2$ of type $TP_3$.

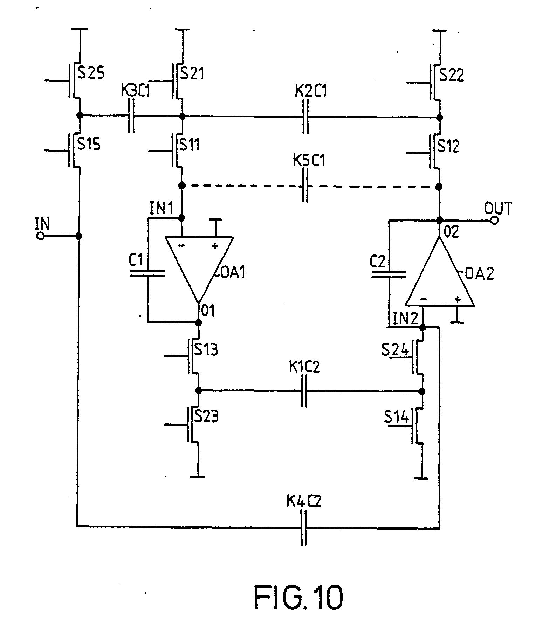

Likewise, and in brief, the biquadratic filter stages of Figures 10 to 16 can be characterized as follows:

Fig. 10:

$O_2$ to $IN_1$: $TP_2$, $CP_1$
$IN$ to $IN_1$: $TP_2$, $CP_1$
$O_1$ to $IN_2$: $TP_1$, $CP_2$
$IN$ to $IN_2$: $TP_3$

Fig. 11:

$O_2$ to $IN_1$: $TP_1$ ($k_2C_1$), $CP_1$
$O_2$ to $IN_1$: $TP_2$ ($k_3C_1$), $CP_1$
$O_1$ to $IN_2$: $TP_1$, $CP_2$
$IN$ to $IN_2$: $TP_4$, $CP_2$

Fig. 12:

$O_2$ to $IN_1$: $TP_1$ ($k_2C_1$), $CP_2$
$O_2$ to $IN_1$: $TP_1$ ($k_3C_1$), $CP_1$
$O_1$ to $IN_2$: $TP_2$, $CP_2$
$IN_1$ to $IN_2$: $TP_4$, $CP_2$

Fig. 13:

$O_2$ to $IN_1$: $TP_2$ ($k_2C_1$), $CP_2$
$O_2$ to $IN_1$: $TP_1$ ($k_3C_1$), $CP_2$
$IN$ to $IN_1$: $TP_4$, $CP_2$
$O_1$ to $IN_2$: $TP_1$ ($k_1C_2$), $CP_1$
$O_1$ to $IN_2$: $TP_4$ ($k_5C_2$), $CP_2$

Fig. 14:

$O_2$ to $IN_1$: $TP_1$ ($k_2C_1$), $CP_1$
$O_2$ to $IN_1$: $TP_1$ ($k_3C_1$), $CP_2$
$IN$ to $IN_1$: $TP_4$, $CP_2$
$O_2$ to $IN_2$: $TP_2$ ($k_1C_2$), $CP_2$
$O_2$ to $IN_2$: $TP_4$ ($k_5C_2$), $CP_1$

Fig. 15:

$O_2$ to $IN_1$: $TP_1$, $CP_1$
$IN$ to $IN_1$: $TP_3$
$O_1$ to $IN_2$: $TP_2$, $CP_2$
$IN$ to $IN_1$: $TP_3$

Fig. 16:
$$O_2 \text{ to } IN_1: TP_2, CP_1$$
$$IN \text{ to } IN_1: TP_3$$
$$O_1 \text{ to } IN_2: TP_1, CP_2$$
$$IN \text{ to } IN_2: TP_3$$

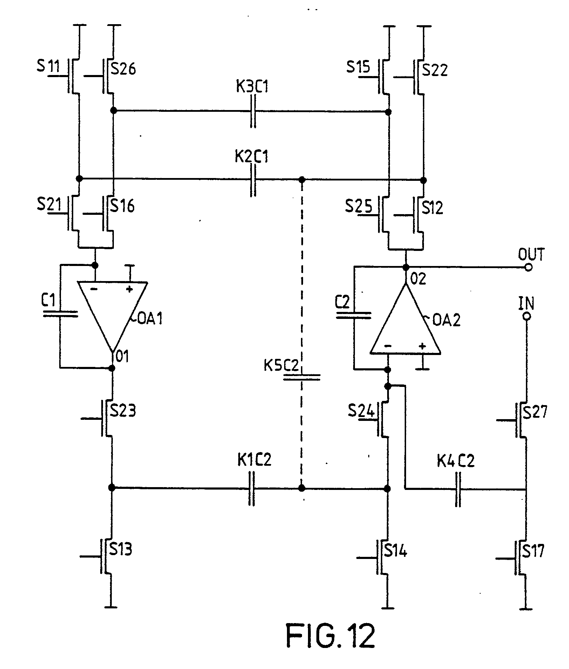

All these biquadratic filter stages, except the one of Fig. 12 are characterized by the fact that the capacitors $k_1C_2$ and $k_2C_1$ are connected to $IN_2$ and $IN_1$ on different phases of the clock respectively. A further difference with the prior art is that different combinations of circuits $TP_1$ to $TP_4$ are used.

The above biquadratic filter stages of Figs. 9 to 12 (to be considered without damping capacitor $k_3C_2$) have an infinite quality factor and a transfer function of the form

$$T = -h \frac{z^2 - 2z \cos t_o + 1}{z^2 - 2z \cos t_p + 1} \tag{15}$$

with $h > 0$
and their components satisfy the following relations:

— Figs. 9 to 10 (without $k_5C_2$)
$$k_1k_2 = 2 \ (1 - \cos t_p)$$

$$\frac{k_1k_3}{k_4} = 2 \ (1 - \cos t_o)$$

$$k_4 = h$$

— Fig. 11 (without $k_5C_2$)
$$k_1k_2 = 2 \ (1 - \cos t_o)$$
$$k_1k_3 = 2 \ (\cos t_p - \cos t_o)$$
$$k_1k_3 = 2 \ (\cos t_p - \cos t_o)$$
$$k_4 = h$$
with $t_p < t_o$

— Fig. 12 (without $k_5C_2$)
$$k_1k_2 = 2 \ (1 - \cos t_o)$$
$$k_1k_3 = 2 \ (\cos t_p - \cos t_p)$$
$$k_4 = h$$
with $t_p < t_p$

From these four filter stages one can derive damped filter stages with transfer function:

$$T = -h \frac{z^2 - 2z \cos t_o + 1}{z^2 - 2zR \cos t_p + R^2} \tag{16}$$

with $h > 0$ and $0 < R < 1$
These damped filter stages are also shown in Figs. 9 to 12, now to be considered with the damping capacitor $k_5C_2$. Their components satisfy the following equations:

Fig. 9 (with $k_5C_2$)
$$k_1k_2 = 1 + R^{-2} - 2R^{-1} \cos t_p$$

$$\frac{k_1k_3}{k_4} = 2 \ (1 - \cos t_o)$$

$$k_4 = hR^{-2}$$
$$k_5 = R^{-2} - 1$$

Fig. 10 (with $k_5 C_2$)
$$k_1 k_2 = 1 + R^2 - 2R \cos t_p$$

$$\frac{k_1 k_3}{k_4} = 2 (1 - \cos t_o)$$

$$k_4 = h$$
$$k_1 k_5 = 1 - R^2$$

Fig. 11 (with $k_5 C_2$)
$$k_1 k_2 = 2 (1 - \cos t_o)$$
$$k_1 k_3 = 1 - R^{-2} + 2R^{-1} \cos t_p - 2 \cos t_o$$
$$k_4 = R^{-2} h$$
$$k_5 = 1 - R^{-2}$$
with $t_p < t_o$

Fig. 12 (with $k_5 C_2$)
$$k_1 k_2 = 2 (1 - \cos t_o)$$
$$k_1 k_3 = R^{-2} - 1 + 2 \cos t_o - 2R^{-1} \cos t_p$$
$$k_4 = R^{-2} h$$
$$k_5 = R^{-2} - 1$$
with $t_o < t_p$

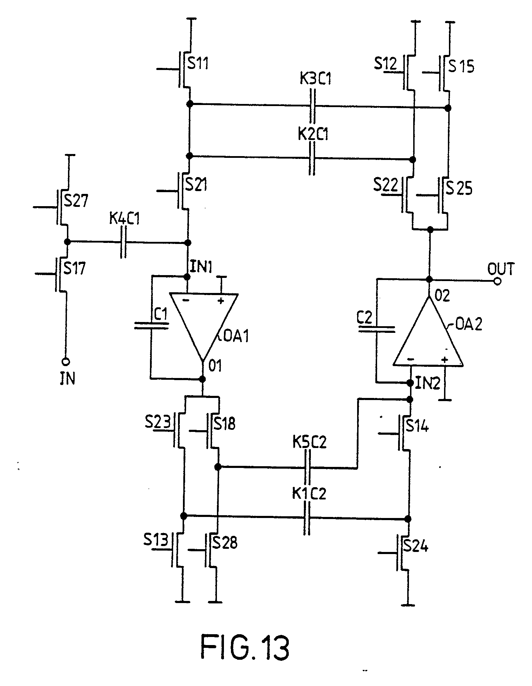

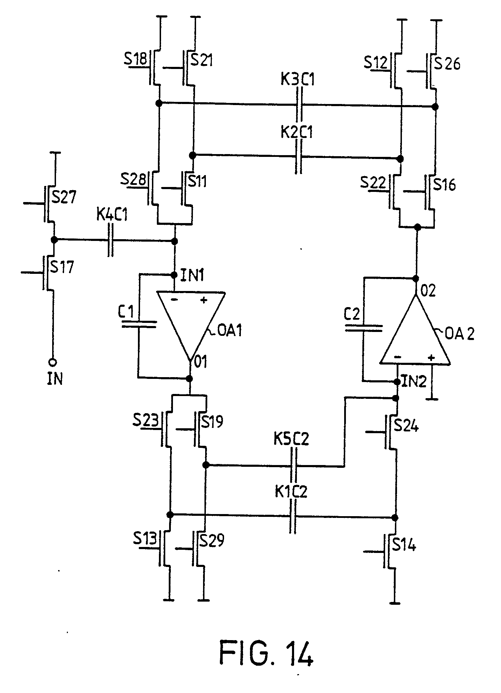

Figs. 13 and 14 show other damped biquadratic stages which realize the transfer function

$$T = h \frac{z^2 - 2z \cos t_o + 1}{z^2 - 2zR \cos t_p + R^2}$$

where $h > 0$ and $0 < R < 1$
Their components satisfy the following relations:

Fig. 13
$$k_1 k_2 = 2 (1 - \cos t_o)$$
$$k_1 k_3 = 1 - R^{-2} + 2R \cos t_p - 2 \cos t_o$$
$$k_3 k_5 = 1 - R^2$$
$$k_4 k_5 = h$$
with $t_p < t_o$

Fig. 14
$$k_1 k_2 = 2 (1 - \cos t_o)$$
$$k_1 k_3 = 1 - R^2 + 2R^2 \cos t_o - 2R \cos t_p$$
$$k_3 k_5 = 1 - R^2$$
$$k_4 k_5 = h$$
with $t_o < t_p$

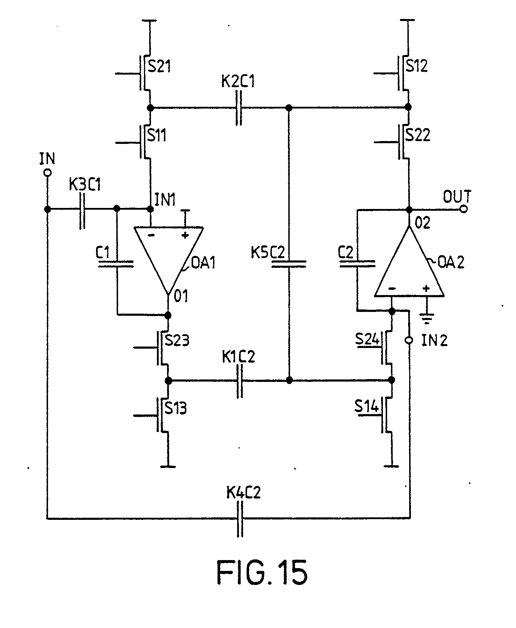

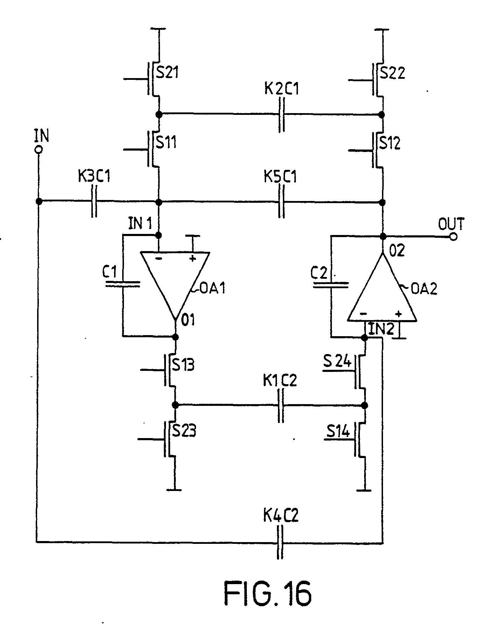

Finally, Figs. 15 and 16 show biquadratic bandpass filter stages realizing the transfer function:

$$T = h \frac{z^2 - 1}{z^2 - 2zR \cos t_p + R^2} \tag{17}$$

with $0 < R < 1$
Their components satisfy the following relations

Fig. 15
$$k_1 k_2 = 1 + R^{-2} - 2R^{-1} \cos t_p$$
$$k_4 = h R^{-2}$$
$$k_1 k_3 = 2h R^{-2}$$
$$k_5 = R^{-2} - 1$$
with $h > 0$

Fig. 16

$$k_1 k_2 = 1 + R^2 - 2R \cos t_p$$
$$k_4 = -h$$
$$k_1 k_3 = -2H$$
$$k_1 k_5 = 1 - R^2$$
$$\text{with } h < 0$$

To understand how the above relations between components of the biquadratic filter stages are obtained, reference is made to the above mentioned article by P. E. Fleischer.

As an example, the relations for Fig. 10 will be given for both the undamped and damped embodiments. When using the same reference as in the article one has:

$$C_1 = D$$
$$C_2 = B$$
$$k_1 C_2 = A$$
$$k_2 C_1 = C$$
$$k_3 C_1 = G$$
$$k_4 C_2 = K$$

and $E = F = H = I = J = L = O$ (for the undamped version) and $E = k_5 C_1$ and $F = H = I = J = L = O$ (for the damped version).

From the article it follows that the transfer functions are:

$$T_u = -\frac{K}{B} \cdot \frac{z^2 + z\left(\dfrac{AG}{DK} - 2\right) + 1}{z^2 + z\left(\dfrac{AC}{DB} - 2\right) + 1} \qquad \text{(undamped version)}$$

$$T_d = -\frac{K}{B} \cdot \frac{z^2 + z\left(\dfrac{AG}{DK} - 2\right) + 1}{z^2 + z\left(\dfrac{AC + AE}{DB} - 2\right) + 1 - \dfrac{AE}{DB}} \qquad \text{(damped version)}$$

On the other hand, from the above it follows (see relations 15 and 16) that these transfer functions should be

$$T_u = -h \frac{z^2 - 2z \cos t_o + 1}{z^2 - 2z \cos t_p + 1}$$

$$T_d = -h \frac{z^2 - 2z \cos t_o + 1}{z^2 - 2zR \cos t_p + R^2}$$

so that the following relations have to be satisfied:

Undamped stage

$$\frac{K}{B} = h$$

$$\frac{AG}{DK} = 2(1 - \cos t_o)$$

$$\frac{AC}{DB} = 2(1 - \cos t_p)$$

EP 0 096 857 B1

Damped stage

$$\frac{K}{B}=h$$

$$\frac{AG}{DK}=2\ (1-\cos\ t_o)$$

$$\frac{AC+AE}{DB}=2\ (1-R\ \cos\ t_p)$$

$$\frac{AE}{DB}=1-R^2$$

Because $B=C_2$ and $D=C_1$, solutions for these equations are

Undamped stage

| | | |
|---|---|---|
| $A=k_1C_2$ | or | $A=k_1C_1$ |
| $C=k_2C_1$ | | $C=k_2C_2$ |
| $G=k_3C_1$ | | $E=k_3C_2$ |
| $K=k_4C_2$ | | $K=k_4C_2$ |

so that $k_4=h$

$$\frac{k_1k_3}{k_4}=2\ (1-\cos\ t_o)$$

$$k_1k_2=2\ (1-\cos\ t_p)$$

which are the relations given above for Fig. 10 (undamped).

Damped stage

| | | |
|---|---|---|
| $A=k_1C_2$ | or | $A=k_1C_1$ |
| $C=k_2C_1$ | | $C=k_2C_2$ |
| $E=k_5C_1$ | | $E=k_5C_2$ |
| $G=k_3C_1$ | | $G=k_3C_2$ |
| $K=k_4C_2$ | | $R=k_4C_2$ |

so that $k_4=h$

$$\frac{k_1k_3}{k_4}=2\ (1-\cos\ t_o)$$

$$k_1k_5=1-R^2$$
$$k_1k_2=1+R^2-2R\ \cos\ t_p$$

which are the relations given above for Fig. 10 (damped).

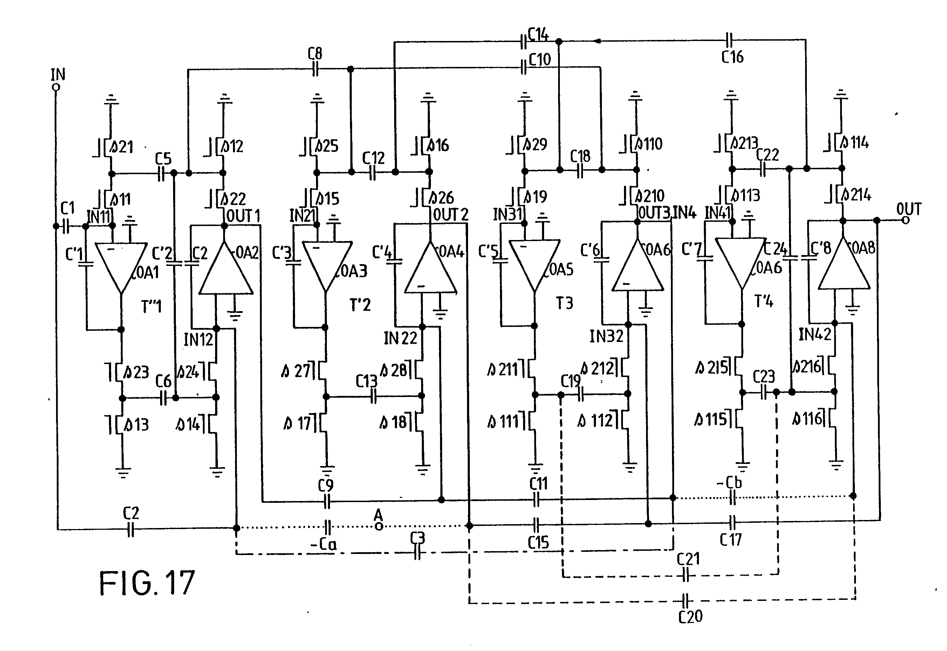

For stages $T''_1$, $T_2$, $T_3$ and $T'_4$ of the bandpass filter of Fig. 17 the following choice has now been made.

Biquadratic filter stage $T''_1$ is a combination, as explained above, or a forward circuit between IN and $OUT_1$ with transfer function

$$\frac{A_1}{P_1}$$

and of a backward circuit between A and $OUT_1$ with transfer function

$$\frac{A_2}{P_1}$$

These transfer functions are respectively provided by the biquadratic filter stages of Fig. 15 and of Fig. 9 (damped and $\cos\ t_{o1}=1$) having substantially the same topology. Indeed, the transfer functions of the stage according to Fig. 15 is (see relation 17)

13

$$h_{11}\frac{z^2-1}{z^2-2zR \cos t_{p1}+R_{11}{}^2}$$

with $h_{11}>0$, and $0<R_{11}<1$ and this function is indeed of the type

$$\frac{A_1}{P_1}$$

whilst the transfer function of the stage of Fig. 9 (damped and with $\cos t_{o1}=1$) is (see relation 16)

$$-h_{12}\frac{(z-1)^2}{z^2-2zR_{12} \cos t_{p1}+R_{12}{}^2}$$

with $h_{12}>0$ and $0<R_{12}<1$
and this is indeed of the type

$$\frac{A_2}{P_2}$$

This merging of the stages of Figs. 15 and 9 in one single stage is important because it ensures a perfect matching of the pole and zero at $z=\pm1$.

Biquadratic stages $T_2$ and $T_3$ are of the type shown in Fig. 9 without damping capacitor $k_5C_2$. They have the respective transfer functions (see relation 15)

$$T_2=-h_2\frac{z^2-2z \cos t_{o2}+1}{z^2-2z \cos t_p 2+1}$$

with $h_2>0$

$$T_3=-h_3\frac{z^2-2z \cos t_{o3}+1}{z^2-2z \cos t_{p3}+1}$$

with $h_3>0$

Finally, biquadratic stage $T'_4$ is of the type shown in Fig. 9 with damping capacitor $k_5C_2$ and $\cos t_{o4}=1$ and having a transfer function (see relation 16)

$$T'_4=h_4\frac{(z-1)^2}{z^2-2zR_4 \cos t_{p4} Z+R_4{}^2}$$

with $h_4>0$ and $0<R_4<1$

In Fig. 17, to be considered with the dotted connections but without the dashed line connections, the stages $T''_1$, $T_2$, $T_3$ and $T'_4$ may be identified in a relatively easy way with the stages of Figs. 15 and 9 (damped and with $\cos t_{o1}=1$); Fig. 9 (undamped); Fig. 9 (undamped) and Fig. 9 (damped and with $\cos t_{o4}=1$) respectively.

The only problems might be the biquadratic stage $T''_1$ and the leapfrog connections between the stages. Both are therefore explained in detail hereinafter.

The stage of Figs. 15 and Fig. 9 only differ in the connection of their entries and therefore it was possible to use in Fig. 17 for $T''_1$ a same circuit with an input IN, constituting the input of the filter and connected as in Fig. 15, and with another input A connected as in Fig. 9. However, because the signal at the input A should be positive (see Fig. 8) but is negative at the output $OUT_2$ (see the transfer function of $T_2$) to which A is coupled a negative capacitor $-Ca$ corresponding to $k_4C_2$ in Fig. 9 has to be used.

From 8 it also follows that $OUT_1$ of $T''_1$ and the output $OUT_3$ of $T_3$ are both connected to the input of $T_2$ via a summing circuit $S_2$. In Fig. 17 the output $OUT_1$ is coupled to the inputs $IN_{21}$ and $IN_{22}$ of $T_2$ via capacitors $C_8$ and $C_9$ corresponding to $k_3C_1$ and $k_4C_2$ in Fig. 9 and the output $OUT_3$ is coupled to the same inputs $IN_{21}$ and $IN_{22}$ via capacitors $C_{10}$ and $C_{11}$ respectively also corresponding to $k_3C_1$ and $k_4C_2$ in Fig. 9. The interconnections between the capacitors $C_8$ and $C_{10}$ as well as between the capacitors $C_2$ and $-Ca$ constitute summing point $S_1$ in Fig. 8. From this figure it also follows that $OUT_2$ of $T_2$ and OUT of $T'_4$ are both connected to the input of $T_3$ via a summing circuit $S_3$. In Fig. 17 output $OUT_2$ is coupled to the inputs

$IN_{31}$ and $IN_{32}$ of $T_3$ via respective capacitors $C_{14}$ and $C_{15}$ corresponding to $k_3C_1$ at $k_4C_2$ in Fig. 9 and the output OUT is coupled to the same inputs $IN_{21}$ and $IN_{22}$ via capacitors $C_{16}$ and $C_{17}$ corresponding to $k_3C_1$ and $k_4C_2$ in Fig. 9. The interconnections between the capacitors $C_{14}$ and $C_{16}$ as well as between the capacitors $C_{15}$ and $C_{17}$ constitute summing point $S_3$ in Fig. 8. The output $OUT_3$ of $T_3$ is also connected to the input $IN_{42}$ via negative capacitor $-Cb$. A negative capacitor $-Cb$ is required because the signal at the output $OUT_3$ of $T_3$ is negative, as follows from the above given transfer function, whereas according to Fig. 8 the signal at the input of $T'_4$ should be positive.

As follows from the above the bandpass filter of Fig. 17 requires two negative capacitors $-Ca$ and $-Cb$ which do not exist. However, by manipulation of the charges on the various capacitors of the circuit these negative capacitors can be removed. Thus finally the filter circuit of Fig. 17 without the dotted connections, but with the dashed line connections is obtained i.e. with

— capacitor $C_3$ between $OUT_3$ and $IN_{12}$;
— capacitor $C_{20}$ between $OUT_2$ and $IN_{42}$;
— and capacitor $C_{21}$ between the junction point of $s_{111}$, $s_{211}$ and $s_{116}$, $s_{216}$.

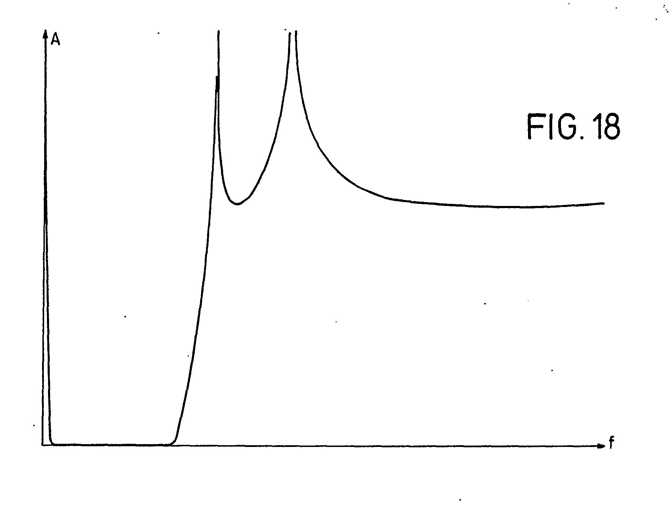

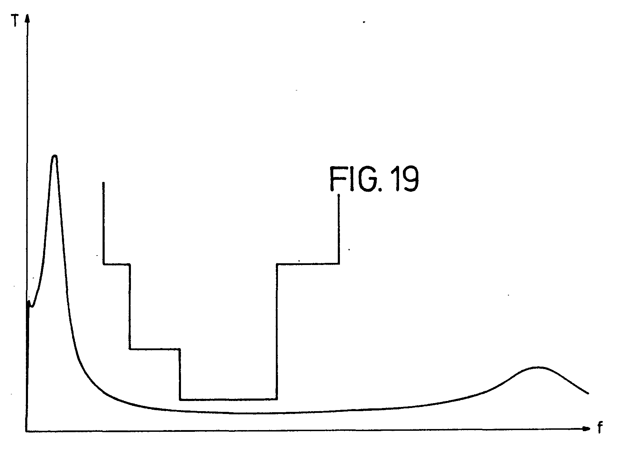

This filter has a transfer function versus frequency characteristic such as shown in Fig. 4. Part of the corresponding attenuation versus frequency characteristic is also represented in Fig. 18. The group delay versus frequency characteristic of the filter is shown in Fig. 19 and fully satisfies the CCITT recommendations as indicated by the gauge.

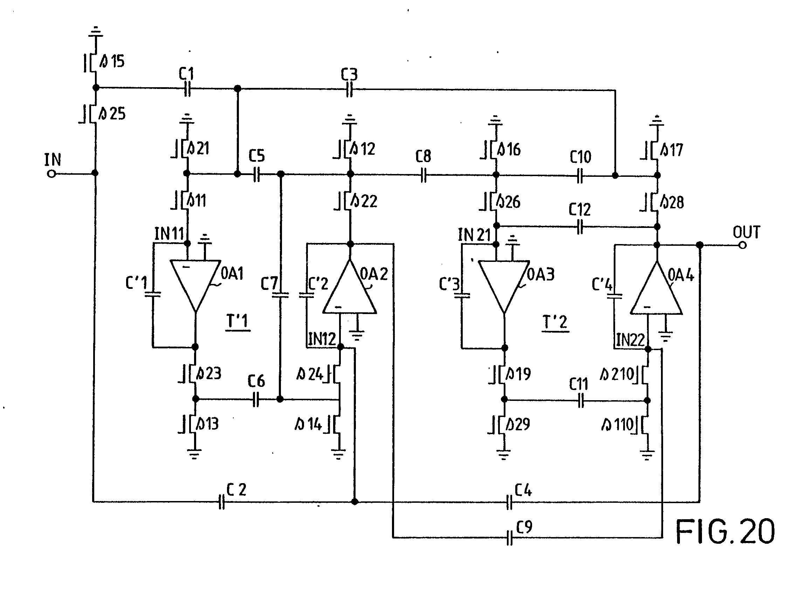

The receive lowpass filter RLPF of Fig. 1 is represented in detail in Fig. 20 and includes biquadratic stages $T'_1$ and $T'_2$ of the type shown in Fig. 9 (damped version) and Fig. 10 (damped version) respectively.

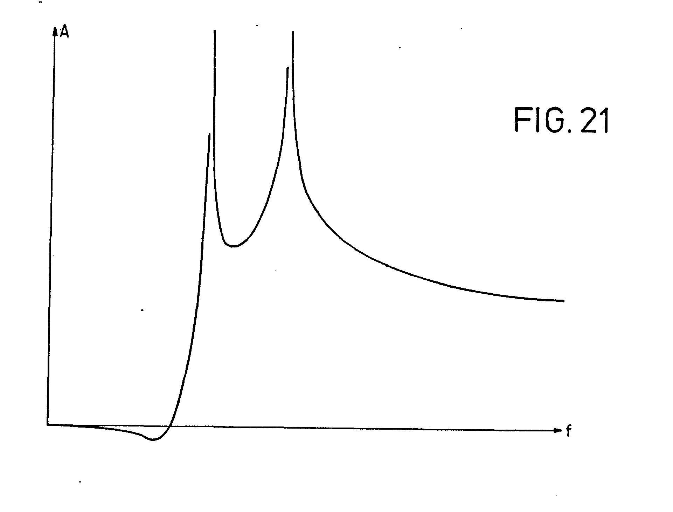

In Fig. 20 capacitors $C_1$ and $C_2$ correspond to capacitors $k_3C_1$ and $k_4C_2$ in Fig. 9 and capacitors $C_8$ and $C_9$ correspond to capacitors $k_3C_1$ and $k_4C_2$ in Fig. 10. The output OUT of $T'_2$ is fed back to $IN_{12}$ and $IN_{22}$ of $T'_1$ via connections including capacitors $C_3$ and $C_4$ respectively. Part of the attenuation versus frequency characteristic of the filter of Fig. 20 is shown in Fig. 21. In the lower passband the above mentioned

$$\frac{\sin x}{x}$$

correction is visible.

**Claims**

1. Leapfrog filter including a plurality of biquadratic filter stages coupled in a leapfrog configuration, characterized in that it is a sampled filter with characteristics equivalent to those of a filter comprising the cascade connection of a first filter part having a transfer function proportional to

$$\frac{z\pm1}{z\mp1}$$

and of a second filter part comprising a plurality of biquadratic filter stages coupled in leapfrog configuration the first and the last stages of which are dissipative for reactive pseudo-power and each have a transfer function proportional to a same factor $(z\mp1)^2$ and the other stages being non-dissipative for reactive pseudo-power, wherein $z=e^{sT}$ with s being the complex frequency and T being the sampling period of the filter.

2. Leapfrog filter according to claim 1, characterized in that the characteristics of said second filter part are equivalent to those of a two-port non-dissipative for reactive pseudo-power coupled between first $(W_1)$ and second $(W_2)$ termination stages dissipative for reactive pseudo-power and having transfer functions $W_1$ and $W_2$ proportional to

$$\frac{z\pm1}{z\mp1}$$

and the reverse thereof respectively.

3. Leapfrog filter according to claim 2, characterized in that the factor $(z\mp1)^2$ to which the transfer function of said first stage of the second filter part is proportional is the numerator of a function

$$T'_1=\frac{T_1}{1+W_1T_1}=h'_1\frac{(z\mp1)^2}{z^2-2zR_1\cos t'_{p1}+R_1^2}$$

whereas

$$W_1=q_1\frac{z\pm1}{z\mp1}$$

is the transfer function of said first termination stage $(W_1)$ and

$$T_1 = h_1 \frac{(z \mp 1)^2}{z^2 - 2z \cos t_{p1} + 1}$$

is the transfer function of the first biquadratic filter stage of said two-port, and whereas $h_1$, $h'_1$ and $q_1$ are positive constants and $t_{p1}$ is the angle of a transmission pole of $T_1$ in the z-plane defined by $z = e^{sT}$.

4. Leapfrog filter according to claim 2, characterized in that the factor $(z \mp 1)^2$ to which the transfer function of said last stage of the second filter part is proportional, is the numerator of a function

$$T'_m = \frac{T_m}{1 + W_2^{-1} T_m} = h'_m \cdot \frac{(z \mp 1)^2}{z^2 - 2z R_m \cos t'_{pm} + R_m^2}$$

whereas

$$W_2 = \frac{1}{q_2} \frac{z \mp 1}{z \pm 1}$$

is the transfer function of said second termination stage $(W_2)$ and

$$T_m = h_m \frac{(z \mp 1)^2}{z^2 - 2z \cos t_{pm} + 1}$$

is the transfer function of the last biquadratic stage of said two-port and wherein $h_m$, $h'_m$ and $q_2$ are positive constants and $t_{pm}$ is the angle of a transmission pole of $T_m$ in the z-plane defined by $z = e^{sT}$.

5. Leapfrog filter according to claim 4, characterized in that it includes a biquadratic filter input stage $(T''_1)$ with a first input (IN) constituting the input of the leapfrog filter, a second input (A) and an output $(OUT_1)$ and includes a forward circuit between said first input and said output $(OUT_1)$ which realizes the transfer function of said first filter part and a feedback circuit between said second input (A) and said output $(OUT_1)$ which realizes the transfer function of said first stage $(T'_1)$ of said second filter part.

6. Leapfrog filter according to claim 5, characterized in that said forward and backward circuits are substantially constituted by a same biquadratic filter circuit.

7. Switched capacitor biquadratic filter circuit adapted for use in leapfrog filters according to anyone of claims with an input and an output and including a non-overlapping two-phase clock source and first and second operational amplifiers each having an inverting input, a grounded non-inverting input, an output and a feedback capacitance, the output of said first amplifier being coupled to the input of said second amplifier via first capacitance means including a first capacitance the plates of which are connected to first and second change-over switches able, under the control of said clock source, to connect them between a ground and said output of said first amplifier and between said ground and the input of said second amplifier, the output of said second amplifier being coupled to the input of said first amplifier via second capacitance means including a second capacitance the plates of which are connected to third and fourth change-over switches able under the control of said clock source, to connect them between said ground and the output of said second amplifier and between said ground and said input of said first amplifier, and said filter input being coupled to an input of one of said amplifiers via third capacitance means including at least a third capacitance, characterized in that said clock source controls said switches ($S_{13}$, $S_{23}$; $S_{14}$, $S_{24}$; $S_{12}$, $S_{22}$; $S_{11}$, $S_{21}$) in such a way that said second capacitor ($k_2 C_1$) is connected to the input ($IN_1$) of said first amplifier ($OA_1$) and said first capacitor ($k_1 C_2$) is connected to said input ($IN_2$) of said second amplifier ($OA_2$) for respective different phases of said clock source.

8. Switched capacitor biquadratic filter circuit adapted for use in leapfrog filters according to anyone of claims with an input and an output and including a non-overlapping two-phase clock source and first and second amplifiers each having an inverting input, a grounded non-inverting input, an output and a feedback capacitance, the output of said first amplifier being coupled to the input of said second amplifier via first capacitance means including a first capacitance the plates of which are connected to first and second change-over switches able, under the control of said clock source, to alternately ground the one and other plates of said first capacitance for different phases of said clock source respectively, the output of said second amplifier being coupled to the input of said first amplifier via second capacitance means including a second capacitance the plates of which are connected to third and fourth change-over switches able, under the control of said clock source, to simultaneously ground both plates of said second capacitance for a same phase of said clock source, said filter input being directly connected to the input of said first amplifier via a third capacitance and to the input of said second amplifier via a fourth capacitance, a damping fifth capacitor being connected between the output of said second amplifier and the input of said first amplifier, characterized in that said clock source controls said switches in such a way that, on the one hand, said

16

second capacitance $(k_2C_1)$ is connected to said input $(IN_1)$ of said first amplifier $(OA_1)$ and, on the other hand, said first capacitance $(k_1C_2)$ is connected to said input $(IN_2)$ of said second amplifier $(OA_2)$ for respective different phases of said clock source.

9. Switched capacitor biquadratic filter circuit according to claim 8, characterized in that it has a transfer function, considered in the z-plane,

$$T = h \frac{z^2 - 1}{z^2 - 2zR \cos t_1 z + R^2}$$

with

$$k_1 k_2 = 1 + R^2 - 2R \cos t_p$$
$$k_4 = -h$$
$$k_1 k_3 = -2h$$
$$k_1 k_5 = 1 - R^2$$

wherein

$t_p$ is the angle of the pole of T;
$k_1C_2$, $k_2C_1$, $k_3C_1$, $k_4C_2$ and $k_5C_2$ are said first, second third, fourth and fifth capacitances and $C_1$ and $C_2$ are said feedback capacitances of said first $(OA_1)$ and second $(OA_2)$ amplifiers respectively;
$k_1$ to $k_5$ and R are positive constants and $h < 0$ and $0 < R < 1$.

10. Switched capacitor biquadratic filter circuit, adapted for use in leapfrog filters according to anyone of claims characterized in that it simultaneously realizes a transfer function proportional to $z^2 - 1$ between a first input (IN) and an output $(OUT_1)$ and a second transfer function proportional to $(z \mp 1)^2$ between a second input (A) and said output the transfer functions being considered in the z-plane.

**Patentansprüche**

1. "Leapfrog"-Filter mit mehreren biquadratischen Filterstufen, die in einer "Leapfrog"-Konfiguration aneinander gekoppelt sind, dadurch gekennzeichnet, daß es ein abgetastetes Filter ist, mit Eigenschaften, die jenen eines Filters äquivalent sind, das eine Kaskadenschaltung eines ersten Filterteils und eines zweiten Filterteils enthält, wobei der erste Filterteil eine zu proportionale Übertragungsfunktion hat und der zweite Filterteil aus mehreren biquadratischen Filterstufen besteht, die in einer "Leapfrog"-Konfiguration aneinander gekoppelt sind, wobei dessen erste und letzte Stufe für reaktive Pseudo-Leistung dissipativ sind und jede von beiden eine zu einem Faktor $(z \mp 1)^2$ proportionale Übertragungsfunktion hat, wobei die anderen Stufen für reaktive Pseudo-Leistung nicht-dissipativ sind, und wobei $z = e^{sT}$ ist, wobei s die komplexe Frequenz und T die Abtastperiode des Filters ist.

2. "Leapfrog"-Filter nach Anspruch 1, dadurch gekennzeichnet, daß die Eigenschaften des zweiten Filterteils äquivalent jenen eines für reaktive Pseudo-Leistung nicht-dissipativen Vierpols, der zwischen eine erste $(W_1)$ und eine zweite $(W_2)$ für reaktive Pseudo-Leistung dissipative Abschlußstufe geschaltet ist, wobei diese beiden Stufen Übertragungsfunktionen $W_1$ und $W_2$ haben, die proportional zu

$$\frac{z \pm 1}{z \mp 1}$$

bzw. zu dem demgegenüber vorzeichen-umgekehrten Faktor haben.

3. "Leapfrog"-Filter nach Anspruch 2, dadurch gekennzeichnet, daß der Faktor $(z \mp 1)^2$, zu dem die Übertragungsfunktion der ersten Stufe des zweiten Filterteils proportional ist, der Zähler einer Funktion

$$T'_1 = \frac{T_1}{1 + W_1 T_1} = h'_1 \frac{(z \mp 1)^2}{z^2 - 2zR_1 \cos t'_{p1} + R_1^2}$$

ist, wobei

$$W_1 = q_1 \frac{z \pm 1}{z \mp 1}$$

die Übertragungsfunktion der ersten Abschlußstufe $(W_1)$ und

$$T_1 = h_1 \frac{(z \mp 1)^2}{z^2 - 2z \cos t_{p1} + 1}$$

die Übertragungsfunktion der ersten biquadratischen Filterstufe des Vierpols ist und wobei $h_1$, $h'_1$ und $q_1$ positive Konstanten und $t_{p1}$ der durch $z = e^{sT}$ definierte Winkel eines Übertragungspols von $T_1$ in der z-Ebene ist.

4. "Leapfrog"-Filter nach Anspruch 2, dadurch gekennzeichnet, daß der Faktor $(z+1)^2$, zu dem die Übertragungsfunktion der letzten Stufe des zweiten Filterteils proportional ist, der Zähler einer Funktion

$$T'_m = \frac{T_m}{1+W_2^{-1}T_m} = h'_m \cdot \frac{(z\mp1)^2}{z^2-2zR_m \cos t'_{pm}+R_m^2}$$

ist, wobei

$$W_2 = \frac{1}{q_2} \quad \frac{z\mp1}{z\pm1}$$

die Übertragungsfunktion der zweiten Abschlußstufe $(W_2)$ ist, und

$$T_m = h_m \frac{(z\mp1)^2}{z^2-2z \cos t_{pm}+1}$$

die Übertragungsfunktion der letzten biquadratischen Stufe des Vierpols ist, wobei $h_m$, $h'_m$ und $q_2$ positive Konstanten und $t_{pm}$ der durch $z=e^{sT}$ in der z-Ebene definierte Winkel eines Übertragungspols von $T_m$ ist.

5. "Leapfrog"-Filter nach Anspruch 4, dadurch gekennzeichnet, daß er eine biquadratische Filter-Eingangsstufe $(T''_1)$ mit einem ersten Eingang (IN) enthält, der den Eingang des "Leapfrog"-Filters bildet, mit einem zweiten Eingang (A) und einem Ausgang $(OUT_1)$ und eine Vorwärts-Schaltung zwischen dem ersten Eingang und dem Ausgang $(OUT_1)$, die die Übertragungsfunktion des ersten Filterteils realisiert, und eine Rückkopplungs-Schaltung zwischen dem zweiten Eingang (A) und dem Ausgang $(OUT_1)$, die die Übertragungsfunktion der ersten Stufe $(T'_1)$ des zweiten Filterteils realisiert.

6. "Leapfrog"-Filter nach Anspruch 5, dadurch gekennzeichnet, daß die Vorwärts- und die Rückkopplungs-Schaltung im wesentlichen durch biquadratische Filterschaltungen von gleichem Aufbau gebildet sind.

7. Biquadratische Filterschaltung mit geschalteten Kondensatoren, ausgelegt zur Verwendung in "Leapfrog"-Filtern nach irgendeinem der vorstehenden Ansprüche, mit einem Eingang und einem Ausgang und mit einer Taktquelle für einen nicht-überlappenden zweiphasigen Takt und mit ersten und zweiten Operationsverstärkern, von denen jeder einen invertierenden Eingang, einen geerdeten nichtinvertierenden Eingang, einen Ausgang und eine Rückkopplungs-Kapazität hat, wobei der Ausgang des ersten Operationsverstärkers mit dem Eingang des zweiten Operationsverstärkers über eine erste Kondensator-Schaltung verbunden ist, wobei die erste Kondensator-Schaltung einen ersten Kondensator enthält, dessen Platten mit einem ersten und einem zweiten Umschalter verbunden sind, wobei die Umschalter in der Lage sind, gesteuert von der Taktquelle, die Platten des Kondensators zwischen Erde und den Ausgang des ersten Verstärkers und zwischen Erde und den Eingang des zweiten Verstärkers zu schalten, wobei der Ausgang des zweiten Verstärkers über eine zweite Kondensator-Schaltung, die einen zweiten Kondensator enthält, mit dem Eingang des ersten Operationsverstärkers verbunden ist, wobei die Platten des zweiten Kondensators mit dritten und vierten Umschaltern verbunden sind, die in der Lage sind, gesteuert von der Taktquelle, sie zwischen Erde und den Ausgang des zweiten Verstärkers und zwischen Erde und den Eingang des ersten Verstärkers zu schalten, wobei der Filtereingang mit einem Eingang eines der beiden Verstärker über eine dritte Kondensator-Schaltung mit mindestens einem dritten Kondensator verbunden ist, dadurch gekennzeichnet, daß die Taktquelle die Umschalter $(S_{13}, S_{23}; S_{14}, S_{24}; S_{12}, S_{22}; S_{11}, S_{21})$ derart steuert, daß der zweite Kondensator $(k_2C_1)$ mit dem Eingang $(IN_1)$ des ersten Operationsverstärkers $(OA_1)$ und der erste Kondensator $(k_1C_2)$ mit dem Eingang $(IN_2)$ des zweiten Operationsverstärkers $(OA_2)$ während jeweils unterschiedlicher Phasen der Taktquelle verbunden sind.

8. Biquadratische Filterschaltung mit geschalteten Kondensatoren, ausgelegt zur Verwendung in "Leapfrog"-Filtern nach irgendeinem der Ansprüche 1 bis 6, mit einem Eingang und einem Ausgang und mit einer Taktquelle für einen nicht-überlappenden zweiphasigen Takt und mit ersten und zweiten Operationsverstärkern, von denen jeder einen invertierenden Eingang, einen geerdeten nichtinvertierenden Eingang, einen Ausgang und eine Rückkopplungs-Kapazität hat, wobei der Ausgang des ersten Operationsverstärkers mit dem Eingang des zweiten Operationsverstärkers über eine erste Kondensator-Schaltung verbunden ist, wobei die erste Kondensator-Schaltung einen ersten Kondensator enthält, dessen Platten mit einem ersten und einem zweiten Umschalter verbunden sind, wobei die Umschalter in der Lage sind, gesteuert von der Taktquelle, die Platten des Kondensators abwechselnd in unterschiedlichen Phasen der Taktquelle mit Erdpotential zu verbinden, wobei der Ausgang des zweiten Verstärkers über eine zweite Kondensator-Schaltung, die einen zweiten Kondensator enthält, mit dem Eingang des ersten Operationsverstärkers verbunden ist, wobei die Platten des zweiten Kondensators mit dritten und vierten Umschaltern verbunden sind, die in der Lage sind, gesteuert von der Taktquelle, beide Platten des zweiten Kondensators gleichzeitig und während einer für beide Platten gleichen Phase der Taktquelle mit Erdpotential zu verbinden, wobei der Filtereingang über einen dritten Kondensator mit dem Eingang des ersten Verstärkers und über einen vierten Kondensator mit dem Eingang des zweiten Verstärkers direkt verbunden ist, wobei ein dämpfender fünfter Kondensator zwischen den Ausgang des zweiten Verstärkers und den Eingang des ersten Verstärkers geschaltet ist, dadurch gekennzeichnet, daß die Taktquelle die Umschalter derart steuert, daß für jeweils unterschiedliche Phasen der Taktquelle einerseits der zweite Kondensator ($k_2C_1$) mit dem Eingang ($IN_1$) des ersten Verstärkers ($OA_1$) und andererseits der erste Kondensator ($k_1C_2$) mit dem Eingang ($IN_2$) des zweiten Verstärkers ($OA_2$) verbunden wird.

9. Biquadratische Filterschaltung mit geschalteten Kondensatoren nach Anspruch 8, dadurch gekennzeichnet, daß sie eine in der z-Ebene betrachtete Übertragungsfunktion

$$T = h \frac{z^2 - 1}{z^2 - 2zR \cos t_1 z + R^2}$$

hat, wobei

$k_1k_2 = 1 + R^2 - 2R \cos t_p,$
$k_4 = -h,$
$k_1k_3 = -2h,$
$k_1k_5 = 1 - R^2$ ist,

wobei

$t_p$ der Winkel des Pols von T ist,

$k_1C_2$, $k_2C_1$, $k_3C_1$, $k_4C_2$ und $k_5C_2$ die ersten, zweiten, dritten, vierten und fünften Kapazitäten sind und $C_1$ und $C_2$ die Rückkopplungskapazitäten des ersten ($OA_1$) beziehungsweise des zweiten Operationsverstärkers ($OA_2$) sind, und wobei

$k_1$ bis $k_5$ und R positive Konstanten und $h < 0$ und $0 < R < 1$ sind.

10. Biquadratische Filterschaltung mit geschalteten Kondensatoren, ausgelegt zur Verwendung in "Leapfrog"-Filtern nach einem der Ansprüche 1 bis 6, dadurch gekennzeichnet, daß sie gleichzeitig eine zu $z^2 - 1$ proportionale Übertragungsfunktion zwischen einem ersten Eingang (IN) und einem Ausgang ($OUT_1$) und eine zweite zu $(z \mp 1)^2$ proportionale Übertragungsfunktion zwischen einem zweiten Eingang (A) und dem Ausgang realisiert, wobei die Übertragungsfunktionen in der z-Ebene betrachtet sind.

**Revendications**

1. Un filtre du type "leapfrog" ou saute-mouton comportant une pluralité d'étages à filtres biquadratiques couplés dans une figuration saute-mouton, caractérisé en ce que le filtre est un filtre échantillonné ayant des caractéristiques équivalentes à celles d'un filtre comprenant la connexion en cascade d'une première partie de filtre ayant une fonction de transfert proportionnelle à

$$\frac{z \pm 1}{z \mp 1}$$

et d'une deuxième partie de filtre comportant une pluralité d'étages à filtres biquadratiques couplés dans une configuration saute-mouton dont le premier et le dernier étages sont dissipatifs pour la pseudo-puissance réactive et chacun ayant une fonction de transfert proportionnelle à un même facteur $(z \mp 1)^2$ et les autres étages étant non-dissipatifs pour la pseudo-puissance réactive, dans laquelle $z = e^{sT}$ où s est la fréquence complexe et T est la période d'échantillonnage du filtre.

2. Filtre saute-mouton selon la revendication 1, caractérisé en ce que les caractéristiques de ladite deuxième partie de filtre sont équivalentes à celles d'un quadripôle non-dissipatif pour la pseudo-puissance réactive couplé entre un premier ($W_1$) et un deuxième ($W_2$) étages terminaux dissipatifs pour la pseudo-puissance réactive et ayant des fonctions de transfert $W_1$ et $W_2$ respectivement proportionnelles à l'expression

$$\frac{z \pm 1}{z \mp 1}$$

et à son inverse.

3. Filtre saute-mouton selon la revendication 2, caractérisé en ce que la facteur $(z \mp 1)^2$ auquel est proportionnelle la fonction de transfert dudit premier étage de la deuxième partie de filtre est le numérateur d'une fonction

$$T'_1 = \frac{T_1}{1 + W_1T_1} = h'_1 \frac{(z \mp 1)^2}{z^2 - 2zR_1 \cos t'_{p1} + R_1^2}$$

où

$$W_1 = q_1 \frac{z \pm 1}{z \mp 1}$$

est la fonction de transfert dudit premier étage terminal ($W_1$) et

$$T_1 = h_1 \frac{(z \mp 1)^2}{z^2 - 2z \cos t_{p1} + 1}$$

est la fonction de transfert du premier étage à filtres biquadratiques dudit quadripôle, et où $h_1$, $h'_1$ et $q_1$ sont des constantes positives et $t_{p1}$ est l'angle d'un pole de transmission de $T_1$ dans le plan-z défini par $z = e^{sT}$.

4. Filtre saute-mouton selon la revendication 2, caractérisé en ce que le facteur $(z \mp 1)^2$ auquel la fonction de transfert dudit dernier étage de la deuxième partie de filtre est proportionnelle, est le numérateur d'une fonction

$$T'_m = \frac{T_m}{1 + W_2^{-1} T_m} = h'_m \frac{(z \mp 1)^2}{z^2 - 2z R_m \cos t'_{pm} + R_m{}^2}$$

où

$$W_2 = \frac{1}{q_2} \frac{z \mp 1}{z \pm 1}$$

est la fonction de transfert dudit deuxième étage terminal ($W_2$) et

$$T_m = h_m \frac{(z \mp 1)^2}{z^2 - 2z \cos t_{pm} + 1}$$

est la fonction de transfert du dernier étage biquadratique dudit quadripôle, et où $h_m$, $h'_m$ et $q_2$ sont des constantes positives et $t_{pm}$ est l'angle d'un pôle de transmission de $T_m$ dans le plan-z défini par $z = e^{sT}$.

5. Filtre saute-mouton selon la revendication 4, caractérisé en ce qu'il inclut un étage d'entrée à filtres biquadratiques ($T'_1$) avec une première entrée (IN) constituant l'entrée du filtre saute-mouton, une deuxième entrée (A) et une sortie (OUT$_1$) et qu'il comporte un circuit avant entre ladite première entrée et ladite sortie (OUT$_1$) qui réalise la fonction de transfert de ladite première partie de filtre, et un circuit à réaction entre ladite première entrée (A) et ladite sortie (OUT$_1$) qui réalise la fonction de transfert dudit premier étage ($T'_1$) de ladite deuxième partie de filtre.

6. Filtre saute-mouton selon la revendication 5, caractérisé en ce que lesdits circuits d'action et de réaction sont constitués sensiblement par un même circuit à filtres biquadratiques.

7. Un circuit à filtres biquadratiques à condensateur commuté adapté à l'utilisation dans des filtres saute-mouton selon une des revendications 1 à 6, ayant une entrée et une sortie et comportant une source de signal d'horloge à deux phases non-recouvrante et un premier et un deuxième amplificateurs opérationnels ayant chacun une entrée inverseuse, une entrée non-inverseuse mise à la masse, une sortie et un condensateur de réaction, la sortie dudit premier amplificateur étant couplée à l'entrée dudit deuxième amplificateur à travers des premiers moyens de condensateur comprenant un premier condensateur dont les plaques sont connectées à un premier et un deuxième inverseurs capables, sous la commande de ladite source de signal d'horloge, de les connecter entre la masse et ladite sortie dudit premier amplificateur et entre ladite masse et l'entrée dudit deuxième amplificateur, la sortie dudit deuxième amplificateur étant couplée à l'entrée dudit premier amplificateur à travers des deuxièmes moyens de condensateur comportant un deuxième condensateur dont les plaques sont connectées à un troisième et un quatrième inverseurs capables, sous la commande de ladite source de signal d'horloge, de connecter lesdites plaques entre ladite masse et la sortie dudit deuxième amplificateur et entre ladite masse et ladite entrée dudit premier amplificateur, et ladite entrée du filtre étant couplée à une entrée de l'un desdits amplificateurs à travers des troisièmes moyens de condensateur comportant au moins un troisième condensateur, caractérisé en ce que ladite source de signal d'horloge commande lesdits inverseurs ($S_{13}$, $S_{23}$; $S_{14}$, $S_{24}$; $S_{12}$, $S_{22}$; $S_{11}$, $S_{21}$) d'une telle manière que ledit deuxième condensateur ($k_2 C_1$) est connecté à l'entrée (IN$_1$) dudit premier amplificateur (OA$_1$), et ledit premier condensateur ($k_1 C_2$) est connecté à ladite entrée (IN$_2$) dudit deuxième amplificateur (OA$_2$) pour les différentes phases respectives de ladite source de signal d'horloge.

8. Un circuit à filtres biquadratiques à condensateur commuté adapté pour l'utilisation dans des filtres saute-mouton selon une des revendications 1 à 6, ayant une entrée et une sortie et comportant une source de signal d'horloge à deux phases non-recouvrante et un premier et un deuxième amplificateurs ayant chacun une entrée inverseuse, une entrée non-inverseuse mise à la masse, une sortie et un condensateur

20

EP 0 096 857 B1

de réaction, la sortie dudit premier amplificateur étant couplée à l'entrée dudit deuxième amplificateur à travers des premiers moyens de condensateur comprenant un premier condensateur dont les plaques sont connectées à un premier et un deuxième inverseurs capables, sous la commande de ladite source de signal d'horloge, de mettre alternativement à la masse l'une et l'autre des plaques dudit premier condensateur pour des phases différentes de ladite source de signal d'horloge respectivement, la sortie dudit deuxième amplificateur étant couplée à l'entrée dudit premier amplificateur à travers des deuxièmes moyens de condensateur comportant un deuxième condensateur dont les plaques sont connectées à un troisième et un quatrième inverseurs capables, sous la commande de ladite source de signal d'horloge, de mettre simultanément à la terre les deux plaques dudit deuxième condensateur pour une même phase de ladite source de signal d'horloge, ladite entrée du filtre étant directement couplée à l'entrée dudit premier amplificateur via un troisième condensateur et à l'entrée dudit second amplificateur via un quatrième condensateur, un cinquième condensateur d'amortissement étant relié entre la sortie dudit second amplificateur et l'entrée dudit premier amplificateur, caractérisé en ce que ladite source de signal d'horloge commande lesdits inverseurs d'une telle manière que, d'une part, ledit deuxième condensateur $(k_2C_1)$ soit connecté à ladite entrée $(IN_1)$ dudit premier amplificateur $(OA_1)$ et, d'autre part, ledit premier condensateur $(k_1C_2)$ soit connecté à ladite entrée $(IN_2)$ dudit deuxième amplificateur $(OA_2)$ pour les différentes phases respectives de ladite source de signal d'horloge.

9. Un circuit à filtres biquadratiques à condensateur commuté selon la revendication 8, caractérisé en ce qu'il possède une fonction de transfert, considérée dans le plan-z,

$$T=h\frac{z^2-1}{z^2-2zR\cos t_1z+R^2}$$

avec

$$k_1k_2=1+R^2-2R\cos t_p$$
$$k_4=-h$$
$$k_1k_3=-2h$$
$$k_1k_5=1-R^2$$

où

$t_p$ est l'angle du pôle de T;
$k_1C_2$, $k_2C_1$, $k_3C_1$, $k_4C_2$ et $k_5C_2$ représentent lesdits premier, deuxième, troisième, quatrième et cinquième condensateurs et $C_1$ et $C_2$ sont les condensateurs de réaction desdits premier $(OA_1)$ et deuxième $(OA_2)$ amplificateurs respectivement;
$k_1$ à $k_5$ et R sont des constantes positives et $h<0$ et $0<R<1$.

10. Un circuit à filtres biquadratiques à condensateur commuté adapté pour l'utilisation dans des filtres saute-mouton selon l'une des revendications 1 à 9, caractérisé en ce qu'il réalise simultanément une fonction de transfert proportionnelle à $z^2-1$ entre une première entrée (IN) et une sortie $(OUT_1)$ et une deuxième fonction de transfert proportionnelle à $(z\mp1)^2$ entre une deuxième entrée (A) et ladite sortie, les fonctions de transfert étant considérées dans le plan-z.

SLC

FIG.1

EP 0 096 857 B1

FIG.2

FIG.3

EP 0 096 857 B1

FIG.4

FIG.5

FIG.6

EP 0 096 857 B1

FIG.7

FIG.8

FIG.9

FIG.10

FIG. 11

FIG.12

FIG.13

FIG. 14

FIG.15

FIG.16

FIG.17

EP 0 096 857 B1

FIG. 18

FIG. 19

FIG.20

FIG. 21